(19) Europäisches Patentamt / European Patent Office / Office européen des brevets

(11) **EP 3 157 165 A1**

(12) **EUROPÄISCHE PATENTANMELDUNG**

(43) Veröffentlichungstag:
**19.04.2017 Patentblatt 2017/16**

(51) Int Cl.:
*H02P 29/66* (2016.01)   *G01R 31/34* (2006.01)
*H02P 21/14* (2016.01)   *H02P 23/14* (2006.01)

(21) Anmeldenummer: **16191366.0**

(22) Anmeldetag: **29.09.2016**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(30) Priorität: **06.10.2015 DE 102015012902**

(71) Anmelder: **AUDI AG**
**85045 Ingolstadt (DE)**

(72) Erfinder:
• **Karl, Bernhard**
**85080 Gaimersheim (DE)**
• **Heckel, Thomas**
**85049 Ingolstadt (DE)**
• **Winkelmeyr, Felix**
**85057 Ingolstadt (DE)**

(54) **VERFAHREN ZUM BESTIMMEN EINER TEMPERATUR EINES ROTORS**

(57) Die Erfindung betrifft ein Verfahren zum Bestimmen einer Temperatur $T_R$ eines Rotors (6) einer Elektromaschine (2), der relativ zu einem Stator (4) der Elektromaschine (2) drehbar ist, wobei als Betriebsparameter der Elektromaschine (2) eine am Stator (4) anliegende Spannung $U_S$, ein durch den Stator (4) fließender Strom $I_S$, eine Drehfrequenz $\omega_R$ des Rotors (6), eine Drehfeldfrequenz $\omega_S$ des Stators (4), eine Induktivität $L_R$ des Rotors (6), eine Induktivität $L_S$ des Stators (4) und eine Hauptinduktivität $L_H$ der Elektromaschine (2) ermittelt werden, wobei aus Werten dieser Betriebsparameter ein Wert eines elektrischen Widerstands $R_R$ des Rotors (6) nach:

$$R_R = \frac{\omega_R L_R}{\pm \sqrt{\dfrac{U_S^2 - (L_S \omega_S I_S)^2}{(L_S \omega_S I_S \sigma)^2 - U_S^2}}}$$

mit

$$\sigma = 1 - \frac{L_H^2}{L_S\, L_R}$$

berechnet wird, wobei ein Wert der Temperatur $T_R$ des Rotors (6) in Abhängigkeit des elektrischen Widerstands $R_R$ des Rotors (6) ermittelt wird.

Fig. 1

**Beschreibung**

Die Erfindung betrifft ein Verfahren und eine Vorrichtung zum Bestimmen einer Temperatur eines Rotors einer Elektromaschine.

Eine Elektromaschine, die als Generator und/oder als Motor eingesetzt werden kann, umfasst als Komponenten einen feststehenden Stator sowie einen sich relativ zu dem Stator drehenden Rotor. Zum Betreiben der Elektromaschine ist es unter anderem erforderlich, deren Betriebsparameter aktuell zu erfassen. Da sich jedoch der Rotor bei einem Betrieb der Elektromaschine relativ schnell drehen kann, ist es in der Regel nicht möglich, einige Betriebsparameter des Rotors bspw. durch Messung direkt zu erfassen.

Ein Verfahren zum Betreiben einer fremderregten Synchronmaschine ist aus der Druckschrift DE 10 2010 014 173 A1 bekannt. Hierbei wird mit einem Modell ein Fluss eines Rotors der Synchronmaschine bestimmt und daraus ein Erregerstrom ermittelt.

Ein elektronisch kommutierter Asynchronmotor, der in der Druckschrift DE 10 2008 018 843 A1 beschrieben ist, umfasst einen Sensor zum Ermitteln einer Stellung eines Rotors, wobei auf Grundlage einer ermittelten Stellung eine Temperatur in dem Asynchronmotor zu charakterisieren ist.

Bei einem Verfahren zur Drehmomentregelung für einen Induktionsmotor, das aus der Druckschrift DE 10 03 301 A1 bekannt ist, ist unter anderem vorgesehen, einen Flussvektor eines Rotors des Induktionsmotors zu ermitteln.

In der Druckschrift AT 397 322 B ist ein Regelungssystem für einen Spannungszwischenkreisumrichter bekannt, das dazu ausgebildet ist, unterschiedliche Größen eines Rotors sowie eines Stators zu ermitteln.

In der Druckschrift EP 2 120 329 A2 ist beschrieben, eine Temperatur eines Rotors eines Induktionsmotors auf Grundlage verschiedener Größen, die sich bei einem Betrieb des Induktionsmotors ergeben, abzuschätzen.

Vor diesem Hintergrund werden ein Verfahren und eine Vorrichtung mit den Merkmalen der unabhängigen Patentansprüche vorgestellt. Ausgestaltungen des Verfahrens und der Vorrichtung gehen aus den abhängigen Patentansprüchen und der Beschreibung hervor.

Das erfindungsgemäße Verfahren ist zum Bestimmen einer Temperatur $T_R$ eines Rotors einer Elektromaschine, der relativ zu einem Stator der Elektromaschine drehbar ist, ausgebildet. Dabei werden als Betriebsparameter der Elektromaschine eine am Stator anliegende Spannung $U_S$, ein durch den Stator fließender Strom $I_S$, eine Drehfrequenz $\omega_R$ des Rotors, eine Drehfeldfrequenz $\omega_S$ des Stators, eine Induktivität $L_R$ des Rotors, eine Induktivität $L_S$ des Stators und eine Hauptinduktivität $L_H$ der Elektromaschine ermittelt. Aus Werten dieser Betriebsparameter wird ein Wert eines elektrischen Widerstands $R_R$ des Rotors nach Gleichung (1):

$$R_R = \frac{\omega_R L_R}{\pm \sqrt{\dfrac{U_S^2 - (L_S \omega_S I_S)^2}{(L_S \omega_S\ I_S\ \sigma)^2 - U_S^2}}} \qquad (1)$$

mit

$$\sigma = 1 - \frac{L_H^2}{L_S L_R} \qquad (2)$$

berechnet. Ein aktueller Wert der Temperatur $T_R$ des Rotors wird in Abhängigkeit des elektrischen Widerstands $R_R$ als Betriebsparameter des Rotors ermittelt.

Aktuelle Werte der am Stator anliegenden Spannung $U_S$, des durch den Stator fließenden Stroms $I_S$, der Drehfrequenz $\omega_R$ des Rotors und der Drehfeldfrequenz $\omega_S$ des Stators werden üblicherweise von mindestens einem Messgerät betriebsbegleitend, bspw. in einem Lastbetrieb, gemessen und somit erfasst und/oder ermittelt.

Werte der Induktivität $L_R$ des Rotors, der Induktivität $L_S$ des Stators und der Hauptinduktivität $L_H$ der Elektromaschine werden laut einer Vorgabe, bspw. einer Tabelle oder einer Kennlinie, vorgegeben und erfasst.

Alternativ oder ergänzend werden Werte der Induktivität $L_R$ des Rotors, der Induktivität $L_S$ des Stators und der Hauptinduktivität $L_H$ der Elektromaschine mit mindestens einem Erfassungsgerät in einem Prüfstand, üblicherweise vor einem Betrieb der Elektromaschine, während dem die anderen Betriebsparameter betriebsbegleitend gemessen werden und die aktuelle Temperatur des Rotors zu ermitteln ist, ermittelt. Dabei wird die Vorgabe in Ausgestaltung auf Grundlage der im Prüfstand ermittelten Werte bereitgestellt.

In Ausgestaltung wird zum Bestimmen der Temperatur $T_R$ des Rotors der in Gleichung (3) dargestellte Zusammenhang zwischen der Temperatur $T_R$ und dem Widerstand $R_R$ des Rotors verwendet:

$$\Delta R = \alpha \, R_{R,Ref} \, \Delta T \tag{3}$$

mit

$$\Delta R = R_R - R_{R,Ref} \tag{4}$$

und

$$\Delta T = (T_R - T_{R,Ref}) \tag{5}$$

Dabei ist $R_{R,Ref}$ ein Referenzwert für den Widerstand $R_R$ und $T_{R,Ref}$ ein Referenzwert für die Temperatur $T_R$ des Rotors, wobei diese Referenzwerte zueinander korreliert sind und bspw. ebenfalls in dem Prüfstand ermittelt werden. Dabei ist bspw. $T_{R,Ref}$ = 20°C jener Referenzwert der Temperatur $T_R$, bei dem sich aufgrund von Materialeigenschaften des Rotors der Referenzwert $R_{R,Ref}$ des Widerstands ergibt. In Ausgestaltung ist möglich, mehrere Wertepaare von Referenzwerten $T_{R,Ref}$ und $R_{R,Ref}$ zu ermitteln und als Vorgabe zu speichern. Der aktuelle Wert der Temperatur $T_R$ wird durch den aktuellen Wert des Widerstands $R_R$ in Relation zu $T_{R,Ref}$ und $R_{R,Ref}$ ermittelt. Die einander zugeordneten Referenzwerte $T_{R,Ref}$ und $R_{R,Ref}$ für Temperatur und Widerstand werden in Ausgestaltung ebenfalls im Prüfstand ermittelt.

Daraus ergibt sich Gleichung (6):

$$T_R - T_{R,Ref} = \frac{R_R - R_{R,Ref}}{\alpha \, R_{R,Ref}} \tag{6}$$

Üblicherweise wird der aktuelle Wert der Temperatur $T_R$ des Rotors nach Gleichung (7):

$$T_R = \frac{R_R - R_{R,Ref}}{\alpha \, R_{R,Ref}} + T_{R,Ref} \tag{7}$$

berechnet. Dabei ist $\alpha$ ein vom Material des Rotors abhängiger Koeffizient, $R_{R,Ref}$ der Referenzwert des elektrischen Widerstands $R_R$ des Rotors und $T_{R,Ref}$ der Referenzwert der Temperatur $T_R$ des Rotors. Der Rotor weist den Referenzwert $R_{R,Ref}$ des elektrischen Widerstands $R_R$ auf, wenn der Rotor den Referenzwert $T_{R,Ref}$ der Temperatur $T_R$ aufweist und umgekehrt.

Die erfindungsgemäße Vorrichtung ist zum Bestimmen einer Temperatur $T_R$ eines Rotors einer Elektromaschine, der relativ zu einem Stator der Elektromaschine drehbar ist, ausgebildet und umfasst mindestens ein Messgerät, mindestens ein Erfassungsgerät und ein Steuergerät. Das mindestens eine Messgerät ist dazu ausgebildet, als Betriebsparameter der Elektromaschine eine am Stator anliegende Spannung $U_S$, einen durch den Stator fließenden Strom $I_S$, eine Drehfrequenz $\omega_R$ des Rotors und eine Drehfeldfrequenz $\omega_S$ des Stators zu messen und somit zu ermitteln. Das mindestens eine Erfassungsgerät ist dazu ausgebildet, eine Induktivität $L_S$ des Stators, eine Induktivität $L_R$ des Rotors und eine Hauptinduktivität $L_H$ der Elektromaschine zu ermitteln. Das Steuergerät ist dazu ausgebildet, aus Werten dieser Betriebsparameter einen Wert eines elektrischen Widerstands $R_R$ des Rotors nach:

$$R_R = \frac{\omega_R L_R}{\pm \sqrt{\dfrac{U_S^2 - (L_S \omega_S I_S)^2}{(L_S \omega_S I_S \sigma)^2 - U_S^2}}} \tag{1}$$

mit

$$\sigma = 1 - \frac{L_H^2}{L_S L_R} \tag{2}$$

zu berechnen und einen aktuellen Wert der Temperatur $T_R$ des Rotors in Abhängigkeit des elektrischen Widerstands $R_R$ des Rotors zu ermitteln.

Hierbei ist ein erstes Messgerät als ein dem Stator zugeordnetes und/oder zuzuordnendes Spannungsmessgerät ausgebildet, das dazu ausgebildet ist, mindestens einen Wert der am Stator anliegenden Spannung $U_S$ zu messen. Ein zweites Messgerät ist als ein dem Stator zugeordnetes und/oder zuzuordnendes Messgerät ausgebildet, das dazu ausgebildet ist, mindestens einen Wert des durch den Stator fließenden Stroms $I_S$ zu erfassen. Ein drittes Messgerät ist als ein dem Rotor zugeordnetes und/oder zuzuordnendes Drehfrequenzmessgerät bzw. Drehzahlmessgerät ausgebildet, das dazu ausgebildet ist, mindestens einen Wert der Drehfrequenz $\omega_R$ des Rotors zu ermitteln. Ein viertes Messgerät ist als ein dem Stator zugeordnetes und/oder zuzuordnendes Drehfeldfrequenzmessgerät ausgebildet, das dazu ausgebildet ist, mindestens einen Wert der Drehfeldfrequenz $\omega_S$ des Stators zu messen.

Somit werden mit dem mindestens einen Messgerät und/oder Erfassungsgerät Werte von elektrischen sowie mechanischen Betriebsparametern mindestens einer Komponente, d. h. dem Stator und/oder dem Rotor der Elektromaschine gemessen und/oder erfasst.

Das Steuergerät umfasst in der Regel eine Recheneinheit und eine Speichereinheit. Werte der Induktivität $L_R$ des Rotors, der Induktivität $L_S$ des Stators und der Hauptinduktivität $I_H$ der Elektromaschine sind laut einer Vorgabe, bspw. aus einer Tabelle oder Kennlinie, zu erfassen, wobei diese Vorgabe, die als Tabelle oder Kennlinie bereitstellbar ist, in der Speichereinheit gespeichert ist.

Die Vorrichtung umfasst außerdem einen Prüfstand, der mehrere Erfassungsgeräte aufweist, wobei ein erstes Erfassungsgerät dem Rotor zugeordnet und/oder zuzuordnen sowie dazu ausgebildet ist, mindestens einen Wert der Induktivität $L_R$ des Rotors zu erfassen, wobei ein zweites Erfassungsgerät dem Stator zugeordnet und/oder zuzuordnen sowie dazu ausgebildet ist, mindestens einen Wert der Induktivität $L_S$ des Stators zu ermitteln, wobei ein drittes Erfassungsgerät der Elektromaschine zugeordnet und/oder zuzuordnen sowie dazu ausgebildet ist, mindestens einen Wert der Hauptinduktivität $L_H$ der Elektromaschine zu ermitteln.

Üblicherweise dreht sich der Rotor als erste Komponente der Elektromaschine bei einem Betrieb der Elektromaschine relativ zu dem Stator als der zweiten Komponente der Elektromaschine. Dabei weist eine der beiden Komponenten, üblicherweise der Rotor, Permanentmagnete auf, die ein permanentes Magnetfeld erzeugen. Die andere der beiden Komponenten, üblicherweise der Stator, weist dagegen mehrere Spulen auf. Die Elektromaschine ist als Motor und/oder als Generator zu betreiben. Bei einem Betrieb als Motor wird durch die Spulen elektrischer Strom geleitet und somit ein Magnetfeld induziert, das mit dem permanenten Magnetfeld interagiert. Auf diese Weise ist es möglich, mit der Elektromaschine elektrische Energie in mechanische Energie, üblicherweise Rotationsenergie, umzuwandeln. Falls die Elektromaschine alternativ oder ergänzend als Generator betrieben wird, wird der Rotor mechanisch in Rotation versetzt, wobei in den Spulen ein Strom induziert und somit mechanische Energie in elektrische Energie umgewandelt wird.

Bei Durchführung des Verfahrens wird die Temperatur der bspw. als Asynchronmaschine ausgebildeten Elektromaschine über den zu ermittelnden elektrischen Widerstand des Rotors indirekt ermittelt. Somit ist es nicht erforderlich, an dem Rotor einen Temperatursensor bzw. ein Thermometer anzuordnen. Weiterhin ist möglich, mittels eines Temperaturmodells, das als Vorgabe in dem Steuergerät oder einem Umrichter der Elektromaschine gespeichert ist, aus dem erfassten aktuellen Wert des Widerstands des Rotors unter Berücksichtigung einer Abhängigkeit der Temperatur von dem Widerstand den Wert der Temperatur zu ermitteln. In weiterer möglicher Ausgestaltung ist zum Bestimmen der Temperatur des Rotors vorgesehen, auch Werte eines Lastverlaufs der Elektromaschine und/oder einer Temperatur des Stators zu berücksichtigen.

Im Rahmen des Verfahrens ist es somit nicht mehr erforderlich, die Temperatur des Rotors bei einem Start der Elektromaschine zu kennen. Weiterhin wird die Temperatur berechnet anstatt lediglich abgeschätzt. Das Verfahren ist auch dann durchführbar, falls die Temperatur des Rotors nach einem Wiederstart der Elektromaschine unbekannt sein sollte. Somit ist auch nicht erforderlich, zu wissen, welche Temperatur der Rotor bspw. bei einem Abschalten der Elektromaschine aufgewiesen hat und wieviel Zeit nach Abschalten der Elektromaschine bis zum Wiederstart verstrichen ist.

Bei Umsetzung des Verfahrens wird für die bspw. als Asynchronmaschine ausgebildete Elektromaschine ein direkter Zusammenhang zwischen dem Widerstand und der Temperatur des Rotors berücksichtigt. Im Betrieb, bspw. Lastbetrieb, der Elektromaschine werden mit dem mindestens einen Messgerät, das bspw. in einem Umrichter der Elektromaschine angeordnet ist, die aktuellen Werte des Stroms und der Spannung des Stators gemessen. Die Drehzahl des Rotors wird bspw. mit einem als Drehzahlgeber ausgebildeten Messgerät gemessen. Aus der gemessenen Drehzahl des Rotors wird weiterhin dessen Drehfrequenz abgeleitet.

Die zu berücksichtigenden Induktivitäten des Rotors, des Stators sowie der gesamten Elektromaschine werden vor dem eigentlichen Betrieb bzw. Lastbetrieb der Elektromaschine als Kenngrößen der Elektromaschine ermittelt. Hierbei ist möglich, im Prüfstand eine jeweilige Spannung, die an dem Stator, dem Rotor und/oder der Elektromaschine anliegt sowie einen Strom, der durch den Stator, den Rotor und/oder die Elektromaschine fließt, zu messen und daraus wiederum die genannten Induktivitäten zu bestimmen. Die in dem Prüfstand ermittelten Werte für die Induktivitäten werden in der Speichereinheit des Steuergeräts hinterlegt. Die aktuelle Drehfeldfrequenz, üblicherweise eine Drehfeldfrequenz des Magnetfelds des Stators, wird von dem Umrichter als das mindestens eine Erfassungsgerät erfasst und/oder ermittelt. Dabei wird dieses Magnetfeld bspw. durch den Strom, der durch die Spulen, üblicherweise Spulen des Stators fließt, induziert.

Weitere Vorteile und Ausgestaltungen der Erfindung ergeben sich aus der Beschreibung und der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand einer Ausführungsform in der Zeichnung schematisch dargestellt und wird unter Bezugnahme auf die Zeichnung schematisch und ausführlich beschrieben.

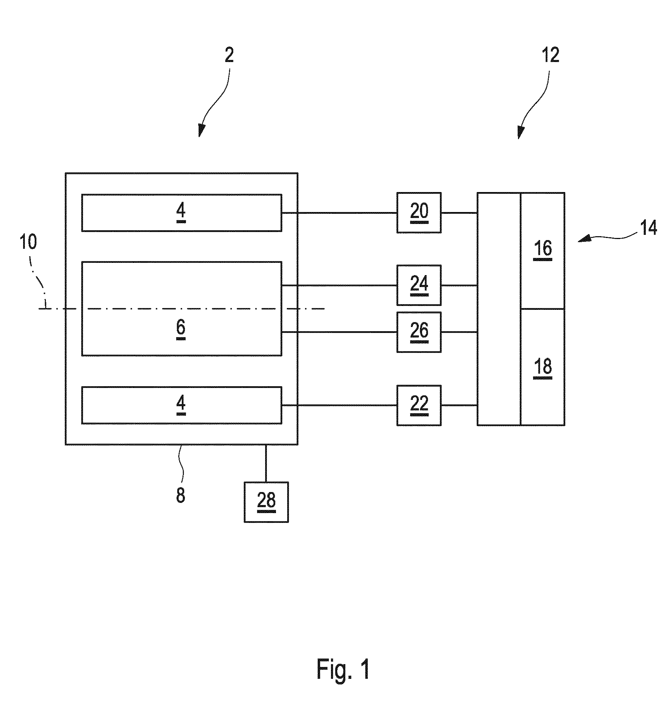

Figur 1 zeigt in schematischer Darstellung einen Längsschnitt durch eine Ausführungsform der erfindungsgemäßen Vorrichtung bei Durchführung einer Ausführungsform des erfindungsgemäßen Verfahrens.

Figur 1 zeigt in schematischer Darstellung eine Elektromaschine 2, die als Komponenten einen Stator 4 sowie einen Rotor 6 aufweist, die beide in einem Gehäuse 8 angeordnet sind, wobei der Stator 4 hier den Rotor 6 zumindest teilweise, ggf. vollständig koaxial umschließt. Dabei ist für den Stator 6 eine Drehachse 10 vorgesehen, die sich bspw. entlang einer Welle der Elektromaschine 2 erstreckt, um die sich der Rotor 6 in einem motorischen und/oder generatorischen Betrieb der Elektromaschine 2 relativ zu dem Stator 4 dreht.

Die erfindungsgemäße Ausführungsform der Vorrichtung 12 umfasst als Komponenten ein Steuergerät 14, das wiederum eine Recheneinheit 16 und eine Speichereinheit 18 umfasst. Außerdem umfasst die Vorrichtung 12 mindestens ein Messgerät 20 sowie mindestens ein Erfassungsgerät 22, die dem Stator 4 zugeordnet und zum Messen und/oder Erfassen mindestens eines Betriebsparameters des Stators 4 ausgebildet sind. Außerdem umfasst die Vorrichtung mindestens ein Messgerät 24 sowie mindestens ein Erfassungsgerät 26, die hier dem Rotor 6 zugeordnet und zum Messen und/oder Erfassen mindestens eines Betriebsparameters des Rotors 6 ausgebildet sind.

In Ausgestaltung ist bzw. sind das Steuergerät 14 sowie mindestens ein Messgerät 20, 24 und/oder mindestens ein Erfassungsgerät 22, 26 als Komponente bzw. Komponenten der Elektromaschine 2, üblicherweise eines Umrichters der Elektromaschine 2 ausgebildet. Mindestens eine Komponente ist weiterhin dazu ausgebildet, mindestens einen Betriebsparameter der Elektromaschine 2 bei einem laufenden Betrieb der Elektromaschine 2, bspw. einem Lastbetrieb, und/oder in einem Prüfstand für die Elektromaschine 2 vor dem eigentlichen Betrieb der Elektromaschine 2 zu messen und/oder zu erfassen.

Dabei wird von dem Messgerät 20 eine an dem Stator 4 anliegende Spannung, ein durch den Stator 4 fließender Strom $I_S$ sowie eine Drehfeldfrequenz $\omega_S$ des Stators 4 gemessen. Dabei gibt die Drehfeldfrequenz $\omega_S$ eine Änderung eines Magnetfelds des Stators 4 an. Von dem Messgerät 24 wird die Drehfrequenz $\omega_R$ des Rotors 6 betriebsbegleitend gemessen. Von dem Erfassungsgerät 22 wird im Prüfstand die Induktivität $L_S$ des Stators 4 erfasst. Außerdem wird von dem Erfassungsgerät 26 ebenfalls im Prüfstand die Induktivität $L_R$ des Rotors 6 erfasst. Mit einem weiteren Erfassungsgerät 28, das der Elektromaschine 2 und somit dem Rotor 4 und dem Stator 6 zugeordnet ist, wird in dem Prüfstand die Induktivität bzw. Hauptinduktivität $I_H$ der gesamten Elektromaschine 2 erfasst. Werte der Induktivitäten, die im Prüfstand vordem eigentlichen Betrieb der Elektromaschine 2 erfasst werden, werden in der Speichereinheit 18 des Steuergeräts 14 gespeichert.

Unter Berücksichtigung der Werte der als Induktivitäten ausgebildeten Betriebsparameter sowie der betriebsbegleitend zu messenden Drehfrequenz, Drehfeldfrequenz und Ströme wird von dem Steuergerät 14, üblicherweise der Recheneinheit 16 des Steuergeräts 14, unter Berücksichtigung der Gleichungen (1) und (2):

$$R_R = \frac{\omega_R L_R}{\pm\sqrt{\dfrac{U_S^2 - (L_S\,\omega_S\,I_S)^2}{(L_S\,\omega_S\,I_S\,\sigma)^2 - U_S^2}}} \qquad (1)$$

mit

$$\sigma = 1 - \frac{L_H^2}{L_S\,L_R} \qquad (2)$$

ein aktueller Wert des Widerstands des Rotors 6 berechnet und somit ermittelt. Weiterhin wird die Temperatur des Rotors 6 unter Berücksichtigung von Gleichung (7):

$$T_R = \frac{R_R - R_{R,Ref}}{\alpha\, R_{R,Ref}} + T_{R,Ref} \qquad\qquad (7)$$

ermittelt. Dabei ist $\alpha$ ein vom Material des Rotors 6 abhängiger Koeffizient, dessen Wert in der Speichereinheit 18 gespeichert ist. Außerdem ist laut Gleichung (7) ein Referenzwert $R_{R,Ref}$ der Temperatur des Rotors sowie ein Referenzwert $T_{R,Ref}$ der Temperatur des Rotors 4 zu berücksichtigen. Dabei ist mindestens ein Wertepaar dieser genannten Referenzwerte $R_{R,Ref}$, $T_{R,Ref}$ ebenfalls in der Speichereinheit 18 abgelegt. Falls in der Speichereinheit 18 mehrere derartige Wertepaare abgelegt sind, bilden diese beispielsweise eine Kennlinie oder eine Tabelle für einen Zusammenhang zwischen der Temperatur und dem Widerstand des Rotors 6.

**Patentansprüche**

1. Verfahren zum Bestimmen einer Temperatur $T_R$ eines Rotors (6) einer Elektromaschine (2), der relativ zu einem Stator (4) der Elektromaschine (2) drehbar ist, wobei als Betriebsparameter der Elektromaschine (2) eine am Stator (4) anliegende Spannung $U_S$, ein durch den Stator (4) fließender Strom $I_S$, eine Drehfrequenz $\omega_R$ des Rotors (6), eine Drehfeldfrequenz $\omega_S$ des Stators (4), eine Induktivität $L_R$ des Rotors (6), eine Induktivität $L_S$ des Stators (4) und eine Hauptinduktivität $L_H$ der Elektromaschine (2) ermittelt werden, wobei aus Werten dieser Betriebsparameter ein Wert eines elektrischen Widerstands $R_R$ des Rotors (6) nach:

$$R_R = \frac{\omega_R L_R}{\pm\sqrt{\dfrac{U_S^2 - (L_S \omega_S I_S)^2}{(L_S \omega_S I_S \sigma)^2 - U_S^2}}}$$

   mit

$$\sigma = 1 - \frac{L_H^2}{L_S\, L_R}$$

   berechnet wird, wobei ein Wert der Temperatur $T_R$ des Rotors (6) in Abhängigkeit des elektrischen Widerstands $R_R$ des Rotors (6) ermittelt wird.

2. Verfahren nach Anspruch 1, bei dem Werte der am Stator (4) anliegenden Spannung $U_S$, des durch den Stator (4) fließenden Stroms $I_S$, der Drehfrequenz $\omega_R$ des Rotors (6) und der Drehfeldfrequenz $\omega_S$ des Stators (6) betriebsbegleitend gemessen werden.

3. Verfahren nach Anspruch 1 oder 2, bei dem Werte der Induktivität $L_R$ des Rotors (6), der Induktivität $L_S$ des Stators (4) und der Hauptinduktivität $L_H$ der Elektromaschine (2) vorgegeben werden.

4. Verfahren nach einem der voranstehenden Ansprüche, bei dem Werte der Induktivität $L_R$ des Rotors (6), der Induktivität $L_S$ des Stators (4) und der Hauptinduktivität $L_H$ der Elektromaschine in einem Prüfstand ermittelt werden.

5. Verfahren nach einem der voranstehenden Ansprüche, bei dem der Wert der Temperatur $T_R$ des Rotors (6) nach:

$$T_R = \frac{R_R - R_{R,Ref}}{\alpha\, R_{R,Ref}} + T_{R,Ref}$$

   berechnet wird, wobei $\alpha$ ein vom Material des Rotors (6) abhängiger Koeffizient, $R_{R,Ref}$ ein Referenzwert des elektrischen Widerstands $R_R$ des Rotors (6) und $T_{R,Ref}$ ein Referenzwert der Temperatur $T_R$ des Rotors (6) ist, wobei der Rotor (6) den Referenzwert $R_{R,Ref}$ des elektrischen Widerstands $R_R$ aufweist, wenn der Rotor (6) den Referenzwert $T_{R,Ref}$ der Temperatur $T_R$ aufweist.

**6.** Vorrichtung zum Bestimmen einer Temperatur $T_R$ eines Rotors (6) einer Elektromaschine (2), der relativ zu einem Stator (4) der Elektromaschine (2) drehbar ist, wobei die Vorrichtung (12) mindestens ein Messgerät (20, 24), mindestens ein Erfassungsgerät (22, 26) und ein Steuergerät (14) aufweist, wobei das mindestens eine Messgerät (20, 24) dazu ausgebildet ist, als Betriebsparameter der Elektromaschine (2) eine am Stator (4) anliegende Spannung $U_S$, einen durch den Stator (4) fließenden Strom $I_S$, eine Drehfrequenz $\omega_R$ des Rotors (6) und eine Drehfeldfrequenz $\omega_S$ des Stators (4) zu ermitteln, wobei das mindestens eine Erfassungsgerät (22, 26) dazu ausgebildet ist eine Induktivität $L_R$ des Rotors, (6) und eine Induktivität $L_S$ des Stators (4) und eine Hauptinduktivität $L_H$ der Elektromaschine (2) zu ermitteln, wobei das Steuergerät (14) dazu ausgebildet ist, aus Werten dieser Betriebsparameter einen Wert eines elektrischen Widerstands $R_R$ des Rotors (6) nach:

$$R_R = \frac{\omega_R L_R}{\pm\sqrt{\dfrac{U_S^2 - (L_S \omega_S\, I_S)^2}{(L_S \omega_S\, I_S \sigma)^2 -\ U_S^2}}}$$

mit

$$\sigma = 1 - \frac{L_H^2}{L_S\, L_R}$$

zu berechnen und einen aktuellen Wert der Temperatur $T_R$ des Rotors (6) in Abhängigkeit des elektrischen Widerstands $R_R$ des Rotors (6) zu ermitteln.

**7.** Vorrichtung nach Anspruch 6, bei der ein erstes Messgerät (20) dem Stator (4) zugeordnet und dazu ausgebildet ist, mindestens einen Wert der am Stator (4) anliegenden Spannung $U_S$ zu messen, bei der ein zweites Messgerät (20) dem Stator (4) zugeordnet und dazu ausgebildet ist, mindestens einen Wert des durch den Stator (4) fließenden Stroms $I_S$ zu erfassen, bei der ein drittes Messgerät (24) dem Rotor (6) zugeordnet und dazu ausgebildet ist, mindestens einen Wert der Drehfrequenz $\omega_R$ des Rotors (6) zu ermitteln, und bei der ein viertes Messgerät (20) dem Stator (4) zugeordnet und dazu ausgebildet ist, mindestens einen Wert der Drehfeldfrequenz $\omega_S$ des Stators (4) zu messen.

**8.** Vorrichtung nach Anspruch 6 oder 7, die einen Prüfstand mit Erfassungsgeräten (22, 26, 28) aufweist, wobei ein erstes Erfassungsgerät (26) dem Rotor (6) zugeordnet und dazu ausgebildet ist, mindestens einen Wert der Induktivität $L_R$ des Rotors zu erfassen, wobei ein zweites Erfassungsgerät (22) dem Stator (4) zugeordnet und dazu ausgebildet ist, mindestens einen Wert der Induktivität $L_S$ des Stators (4) zu ermitteln, wobei ein drittes Erfassungsgerät (28) der Elektromaschine (2) zugeordnet und dazu ausgebildet ist, mindestens einen Wert der $I_H$ Hauptinduktivität der Elektromaschine (2) zu ermitteln.

Fig. 1

# EP 3 157 165 A1

| | Europäisches Patentamt / European Patent Office / Office européen des brevets | **EUROPÄISCHER RECHERCHENBERICHT** | **Nummer der Anmeldung**<br>EP 16 19 1366 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | CN 102 072 779 A (HARBIN INST OF TECHNOLOGY) 25. Mai 2011 (2011-05-25)<br>* Absatz [[0079]] - Absatz [[0128]]; Anspruch 1; Abbildungen 1-2 *<br>----- | 1-8 | INV.<br>H02P29/66<br>G01R31/34<br>H02P21/14<br>H02P23/14 |
| A | DE 37 07 614 A1 (KLEIN SCHANZLIN & BECKER AG [DE]) 22. September 1988 (1988-09-22)<br>* Satz 38 - Satz 39; Ansprüche 1,2 *<br>----- | 1-8 | |

**RECHERCHIERTE SACHGEBIETE (IPC)**

H02P
G01R

Der vorliegende Recherchenbericht wurde für alle Patentansprüche erstellt

| Recherchenort | Abschlußdatum der Recherche | Prüfer |
|---|---|---|
| München | 7. März 2017 | Landi, Matteo |

## ANHANG ZUM EUROPÄISCHEN RECHERCHENBERICHT
## ÜBER DIE EUROPÄISCHE PATENTANMELDUNG NR.

EP 16 19 1366

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

07-03-2017

| Im Recherchenbericht angeführtes Patentdokument | Datum der Veröffentlichung | Mitglied(er) der Patentfamilie | Datum der Veröffentlichung |
|---|---|---|---|
| CN 102072779 A | 25-05-2011 | KEINE | |
| DE 3707614 A1 | 22-09-1988 | KEINE | |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010014173 A1
- DE 102008018843 A1
- DE 1003301 A1
- AT 397322 B
- EP 2120329 A2